# EUROPEAN PATENT APPLICATION

(11) **EP 2 179 893 A1**
(43) Date of publication of application: **28.04.2010**
(21) Application number: 08827221.6
(22) Date of filing: 08.08.2008
(51) Int. Cl.: B60R 11/02, B60R 16/02

(54) **ATTACHING STRUCTURE**

(30) Priority: 13.08.2007 JP 2007210859
(71) Applicant: Nifco INC., Yokohama-shi, Kanagawa 244-8522 (JP)
(72) Inventor: MATSUI, Atsumasa, Toyota-shi Aichi 471-8571 (JP); WATANABE, Mitsunori, Toyota-shi Aichi 471-8571 (JP); IWAMOTO, Tatsuya, Toyota-shi Aichi 471-8571 (JP); UENO, Hiroshi, Toyota-shi Aichi 471-8571 (JP); KATO, Yohei, Toyota-shi Aichi 471-8571 (JP); TANAKA, Hiromasa, Yokohama-shi Kanagawa 244-8522 (JP)
(74) Representative: Gassner, Wolfgang
(86) International application number: PCT/JP2008/064340
(87) International publication number: WO 2009/022662

(57) **Abstract**

In an attachment structure, a vehicle-mounted electronic device is attached to a receiving box using an adjusting member for adjusting a difference between an external dimension of the electronic device and a dimension of a receiving space of the receiving box for receiving the electronic device. The adjusting member has an insertion-coupling device for insertion-coupling the adjusting member and the electronic device, and a first catch-coupling device for catch-coupling the adjusting member and the receiving box. The first catch-coupling device is an appended claw-receiving part that corresponds to a flexible claw on the receiving box, and the direction of insertion-coupling of the insertion-coupling device and the direction of catch-coupling of the first catch-coupling device are different.

## Description

### Field of the Invention

The present invention relates to an attachment structure for supporting a vehicle-mounted electronic device, such as an ECU, in a receiving box which mounts the electronic device in a vehicle such as a passenger car, truck or bus.

### Background Art

A box, more specifically, a receiving box or housing as described in Patent Document 1, has been hitherto proposed in order to centrally place, receive and fix to the vehicle body, a vehicle-mounted electronic device such as an ECU (Electronic Control Unit) for controlling a respective onboard device. A receiving space for receiving such an ECU is provided in such a box. The ECU is received inside the receiving space, and the box is fixed to the vehicle body by a method such as fastening by bolts.
Patent Document 1:
   Publication of Japanese Unexamined Patent No. 2005-153590

### Disclosure of the Invention

### Problem to Be Solved by the Invention

When attempting to adapt such a box to different vehicle types, the ECU to be used also naturally differs with the different vehicle types, and a situation wherein mutually exclusive settings arise in which the ECU having a different dimension must be received inside the same receiving space of the box. In such case, with this conventional box, there is a problem in that it becomes difficult to receive and fix the ECUs, having different dimensions, inside the same receiving space. It therefore becomes difficult to make the same box universally adaptive to different vehicle types.

In consideration of the above problem, an object of the present invention is to provide a structure for attaching an electronic device to a receiving box using an adjusting member, whereby the receiving box can be commonly or universally used in different vehicle types.

### Means for Solving the Problem

In order to solve the above problem, the attachment structure according to the present invention utilizes an attachment structure for supporting a vehicle-mounted electronic device in a receiving box using an adjusting member for adjusting a difference between an external dimension of the electronic device and a dimension of a receiving space of the receiving box. The adjusting member has an insertion-coupling means for insertion-coupling the adjusting member and the electronic device. The adjusting member or the electronic device has a first catch-coupling means for catch-coupling the adjusting member or the electronic device and the receiving box. The first catch-coupling means takes the form of an appended claw-receiving part that corresponds to a flexible claw on the receiving box. This causes the direction of insertion-coupling of the insertion-coupling means and the direction of the catch-coupling of the first catch-coupling means, to be respectively different.

The direction of adjustment may be any direction, and may be the direction that the electronic device is inserted when being inserted into the receiving box, that is, the direction of the catch-coupling or a direction perpendicular to the direction of catch-coupling. For example, in the case when the direction of catch-coupling is the front-back (fore-aft) direction of the vehicle, the perpendicular direction includes the vertical direction and the left-right (lateral) direction of the vehicle.

The electronic device is, for example, an ECU, the receiving box is, for example, a box, and the adjusting member is, for example, an adaptor.

Because the direction of insertion-coupling of the insertion-coupling means and the direction of catch-coupling of the first catch-coupling means are respectively different, when the electronic device and the adjusting member are interconnected and rendered a unit, and are inserted into the receiving space of the receiving box to be catch-coupled, the action of a force influencing the insertion-coupling of the electronic device and the adjusting member by the insertion-coupling means, is such that consequent loosening of the insertion-coupling, is prevented. Accordingly, insertion of the electronic device in the receiving box can be accomplished smoothly.

Furthermore, because the adjusting member or the electronic device has a first catch-coupling means for catch-coupling the adjusting member or the electronic device and the receiving box, after the electronic device is insertion-coupled in the adjusting member by the insertion-coupling means and the electronic member and the adjusting member are interconnected and rendered a unit, the adjusting member and the electronic device are inserted inside the receiving space of the receiving box and are catch-coupled by the first catch-coupling means. Accordingly, an electronic device having different dimension from the receiving space of the receiving box can be received in the receiving space. With this, the receiving box can be made common (viz., universally used) among different vehicle types.

Furthermore, because the first catch-coupling means is an appended claw-receiving part that corresponds to a flexible claw on the receiving box, the first catch-coupling means can be used with the appended claw-receiving part in a state which corresponds to the flexible claw originally on the receiving box, and when the electronic device is received inside the receiving space of the receiving box after the difference between the external dimension of the electronic device and the receiving space of the receiving box is adjusted by the adjusting member, accommodation can be made by changing only the adjusting member without making changes to the electronic device or the receiving box.

Here, in the case when there is no difference between the external dimension of the electronic device and the dimension of the receiving space of the receiving box, the flexible claw on the receiving box is the claw for catch-coupling with the electronic device which is inserted into the receiving space of the receiving box. In this case, the electronic device has a claw-receiving part that corresponds to this flexible claw.

The attachment structure is preferably such that the direction of insertion-coupling of the insertion-coupling means and the direction of catch-coupling of the first catch-coupling means are orthogonal.

With this, because the direction of insertion-coupling of the insertion-coupling means and the direction of catch-coupling of the first catch-coupling means are orthogonal, when the electronic device and the adjusting member which are interconnected and rendered a unit, are inserted inside the receiving space of the receiving box and are catch-coupled, the action of a force influencing the insertion-coupling of the electronic device and the adjusting member by the insertion-coupling means, consequent loosening of the insertion-coupling, is prevented effectively, and the reception of the electronic device in the receiving box can be accomplished smoothly.

The attachment structure may be such that: the flexible claw has an edge part that faces the front in the direction of catch-coupling, and an inclined face that inclines so as to move away from the electronic device from the front to back in the direction of catch-coupling. The appended claw-receiving part has a wall part toward the front in the direction of catch-coupling.

With this, after the electronic device and the adjusting member are interconnected and rendered a unit, when the adjusting member is inserted inside the receiving space of the receiving box and is catch-coupled by the first catch-coupling means, the flexible claw is pushed inward by the adjusting member in the direction moving away from the electronic device by the force of insertion in the direction of the catch-coupling. When the adjusting member and the electronic device are inserted up to the position where the flexible claw reaches the appended claw-receiving part, the flexible claw pushes outward in the direction moving closer to the electronic device on the appended claw-receiving part, and the edge part contacts with the wall part, whereby the adjusting member can be catch-coupled with the receiving box.

Here, the attachment structure may be such that: the electronic device has a connector toward the back in the direction of catch-coupling; and the adjusting member has an upper part and a lower part, and a connecting part connecting the upper part and the lower part toward the front with respect to the direction of catch-coupling.

Alternatively, the attachment structure may be such that: the electronic device has a connector toward the back in the direction of catch-coupling; and the adjusting member has an upper part a lower part, and a connecting part connecting the upper part and the lower part in the direction of catch-coupling.

By either of the above, after the adjusting member which is rendered a unit with the electronic device, is inserted inside the receiving box and is catch-coupled, the connector of the electronic device is positioned toward the back in the direction of catch-coupling, and the wiring distribution scheme of the electronic device is easy.

Alternatively, the attachment structure may be such that: the adjusting member is a binary or two piece structure.

In this case also, after the adjusting member is rendered a unit with the electronic device and is inserted into the receiving box and is catch-coupled, the connector of the electronic device is positioned toward the back in the direction of catch-coupling, and the wiring distribution scheme of the electronic device is facilitated.

In this case, the attachment structure is preferably such that: the insertion-coupling means on one side and the insertion-coupling means on the other side of the adjusting member having the binary structure, are positioned in the center in the direction of catch-coupling.

With this, the sides of the adjusting member having the binary structure can be made common.

Furthermore, the adjusting member may have preventing means for preventing improper receiving when receiving the electronic device in the receiving space of the receiving box.

With this, improper disposition of the electronic device can be prevented.

Alternatively, in order to solve the above problem, the attachment structure is such that the adjusting member has a fixing means for fixing the adjusting member and the receiving box, and a second catch-coupling means for catch-coupling the adjusting member and the electronic device. Further, the second catch-coupling means is an appended flexible claw that corresponds to a claw-receiving part on the electronic device, and has clasping means for clasping wiring of the electronic device.

With this arrangement, because the adjusting member has a clasping means for clasping wiring of the electronic device, the wiring of the electronic device can be clasped and fixed using the adjusting member positioned between the electronic device and the receiving box, and the adjusting member can be utilized more effectively. Further, the degree of freedom of the wiring distribution scheme of the electronic device can be increased with the direction of the wiring distribution scheme of the electronic device being prearranged in the clasping means.

Furthermore, because the adjusting member has a second catch-coupling means for catch-coupling the adjusting member and the electronic device, after the adjusting member is fixed to the receiving box by the fixing means, and the adjusting member and the receiving box are made as a unit, the electronic device is catch-coupled by the second catch-coupling means in the receiving space of the receiving box adjusted by the adjusting member, and the electronic device having a different dimension from the receiving space of the receiving box can be received inside the receiving space. By this, the receiving box can be made common among different vehicle types.

In addition, because the second catch-coupling means is an appended flexible claw that corresponds to a claw-receiving part on the electronic device, the first catch-coupling means can be used with the appended flexible claw made to correspond to the claw-receiving part originally on the electronic device, and when the electronic device is received in the receiving space of the receiving box after the difference between the external dimension of the electronic device and the receiving space of the receiving box is adjusted by the adjusting member, accommodation can be made by changing only the side of the adjusting member without making changes to the electronic device or the receiving box.

Here, in the case when there is no difference between the external dimension of the electronic device and the dimension of the receiving space of the receiving box, the claw-receiving part on the electronic device is the claw-receiving part corresponding to the flexible claw provided on the receiving box, for catch-coupling with the electronic device being inserted into the receiving space of the receiving box.

### Effect of the Invention

According to the present invention, a receiving box can be made common among different vehicle types.

### Brief Description of the Drawings

Figs. 1 (a) to 1(c) are drawings showing one embodiment of the attachment structure according to the present invention,
Fig. 2 is a drawing in sectional view showing the attachment structure according to the present invention,
Fig. 3 is a perspective drawing showing another embodiment of the attachment structure according to the present invention,
Fig. 4 is a drawing showing the attachment structure according to the present invention,
Fig. 5 is a perspective drawing showing a further embodiment of the attachment structure according to the present invention,
Fig. 6 is a drawing showing the attachment structure according to the present invention,
Figs. 7 (a) and 7(b) are drawings showing yet another embodiment of the attachment structure according to the present invention,
Fig. 8 is a drawing showing a further embodiment of the attachment structure according to the present invention, and
Fig. 9 is a drawing showing another embodiment of the attachment structure according to the present invention.

### Preferred Embodiments of the Invention

Preferred embodiments of the present invention are explained below with reference to the drawings.

### Embodiment 1

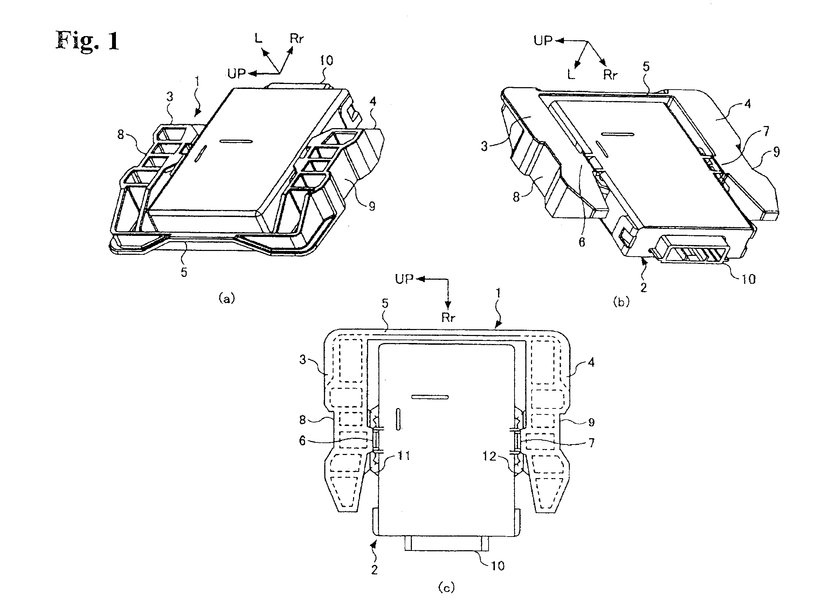

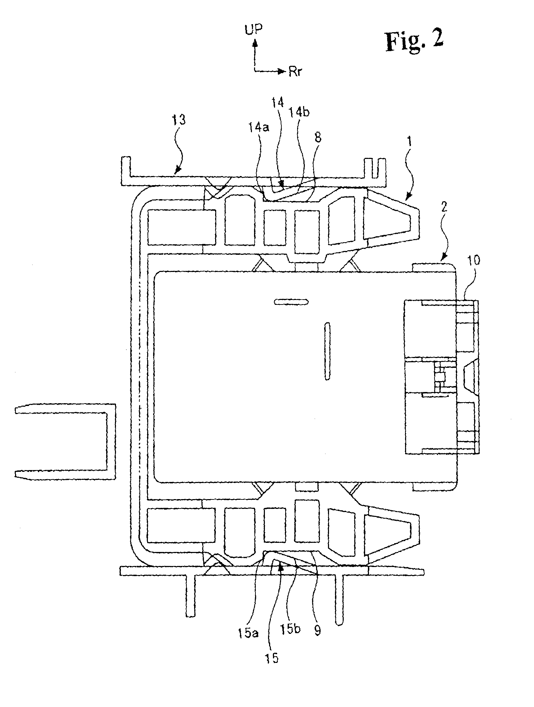

Figs. 1 (a) to 1(c) are drawings showing one embodiment of the attachment structure according to the present invention. Fig. 2 is a drawing in sectional view showing the attachment structure according to the present invention on the section perpendicular to the right-left direction of the vehicle. In Figs. 1 (a) to 1(c) and Fig. 2, Rr indicates a direction toward the rear of the vehicle, L indicates the left of the vehicle, and UP indicates upward.

The adaptor 1 of Embodiment 1 is used for adjusting a difference between an external dimension of an ECU (Electronic Control Unit) 2 and a dimension of a receiving space of a box 13 for receiving this ECU 2, and has an upper part 3, a lower part 4, a connecting part 5, an insertion-coupling part 6, an insertion-coupling part 7, an appended claw-receiving part 8, and an appended claw-receiving part 9, and is unitarily constituted, for example, of polypropylene, or the like. In short, the adaptor 1 constitutes the adjusting member, the ECU 2 constitutes the electronic device, and the box 13 constitutes the receiving box.

Although not shown in detail here, the box 13 is joined such as by bolt-fastening to a dashboard reinforcement extending in the left-right (lateral) direction of the vehicle inside the dashboard in front of the passenger seat side of the vehicle, and the direction of insertion, that is, catch-coupling of the adaptor 1 and the ECU 2 substantially coincides with the front-back direction of the vehicle.

The upper part 3 and the lower part 4 are connected by the connecting part 5 in the direction of catch-coupling of the ECU 2, that is, toward the front of the vehicle, and the adaptor 1 has an angle bracket shape that holds the ECU 2 inside from above and below. The difference of dimension of the ECU 2 and the receiving space of the box 13 in the vertical direction is adjusted by the dimension of the upper part 3 and lower part 4 in the vertical direction, and the difference of dimension of the ECU 2 and the receiving space of the box 13 in the front-back direction of the vehicle is adjusted by the dimension of the connecting part 5 in the front-back direction of the vehicle.

An insertion-coupled part 11 for insertion-coupling the ECU 2 to a bracket on the side of the vehicle body, not illustrated here, is provided on the upper end face of the ECU 2, and an insertion-coupled part 12 for insertion-coupling to a bracket on the side of the vehicle body, not illustrated here, is provided on the lower end face of the ECU 2.

The insertion-coupling part 6 of the adaptor 1 constitutes insertion-coupling means for sliding in the left-right direction of the vehicle, that is, in the direction of thickness of the ECU 2 and insertion-coupling to the insertion-coupled part 11 of the ECU 2. The insertion-coupling part 7 of the adaptor 1 constitutes insertion-coupling means for sliding in the left-right direction of the vehicle, that is, in the direction of thickness of the ECU 2 and insertion-coupling to the insertion-coupled part 12 of the ECU 2.

Also, as shown in Fig. 2, the receiving space of the box 13 originally has a space capable of receiving an ECU for 4WD vehicle having larger dimensions than the ECU 2, but the ECU 2 having smaller dimensions than this receiving space is received therein because this box 13 is to be made common among different vehicle types such as 4WD vehicles and hybrid vehicles.

Therefore, flexible claws 14, 15 corresponding to claw-receiving parts on an ECU for 4WD vehicle having large dimensions are provided on the upper end face and lower end face of the receiving space of the box 13, and the adaptor 1 has an appended claw-receiving part 8 and an appended claw-receiving part 9 corresponding to the flexible claws 14, 15 on this box, and these appended claw-receiving parts 8, 9 constitute a first catch-coupling means for catch-coupling the adaptor 1 and the box 13.

Here, the flexible claw 14 has an edge part 14a that faces the front in the direction of catch-coupling, that is, the front-back (fore-aft) direction of the vehicle, and an inclined face 14b that inclines upward so as to move away from the ECU 2 from the front to back in the direction of catch-coupling, that is, the front-back direction of the vehicle. Likewise, the flexible claw 15 has an edge part 15a that faces the front in the direction of catch-coupling, that is, the front-back direction of the vehicle, and an inclined face 15b that inclines downward so as to move away from the ECU 2 from the front to back in the direction of catch-coupling, that is, the front-back direction of the vehicle.

When the adaptor 1 insertion-coupled with the ECU 2, is inserted into the box 13 from the back to front of the vehicle, the part positioned toward the front of the appended claw-receiving part 8 of the upper part 3 pushes the inclined face 14b of the flexible claw 14 upward in the direction of moving away from the ECU 2, and the part positioned toward the front of the appended claw-receiving part 9 of the lower part 4 pushes the inclined face 15b of the flexible claw 15 downward in the direction of moving away from the ECU 2.

Furthermore, when the adaptor 1 is inserted into the box 13 up to the position where the flexible claw 14 and the flexible claw 15 respectively correspond with the appended claw-receiving parts 8, 9, the upward impelling force no longer acts on the flexible claw 14, and the flexible claw 14 pushes out by its inherent flexibility, that is, spring action inside the appended claw-receiving part 8, so as to approach the ECU 2. Also, the downward impelling force no longer acts on the flexible claw 15, and the flexible claw 15 pushes out by its inherent flexibility, that is, the spring action inside the appended claw-receiving part 9.

The edge parts 14a, 15a, which form flat planes facing the front-back direction of the vehicle and which are substantially perpendicular to the front-back direction of the vehicle, are formed toward the front of the vehicle on these flexible claws 14, 15, and the edge parts 14a, 15a toward the front of the vehicle on these flexible claws 14, 15 contact with wall surfaces toward the front of the vehicle on the appended claw-receiving parts 8, 9, whereby the adaptor 1 is catch-coupled to the box 13 as one body (viz., a unit) with the ECU 2.

Furthermore, in the adaptor 1, the direction of insertion-coupling and the direction of catch-coupling are made orthogonal in respectively different directions, with the direction of insertion-coupling of the insertion-coupling part 6 and the insertion-coupled part 11 and the direction of insertion-coupling of the insertion-coupling part 7 and the insertion-coupled part 12, being the left-right (lateral) direction of the vehicle, and the direction of catch-coupling of the appended claw-receiving part 8 and the flexible claw 14 and the direction of catch-coupling of the appended claw-receiving part 9 and the flexible claw 15 being the front-back direction of the vehicle.

According to the adaptor 1 and attachment structure of Embodiment 1 described above, the following operation and effect can be obtained.

That is, the ECU 2 is insertion-coupled to the adaptor 1 by the insertion-coupling part 6 and the insertion-coupling part 7 of the adaptor 1, and the ECU 2 and the adaptor 1 are interconnected and made as one body or unit. The adaptor 1 is then inserted inside the receiving space of the box 13, and the appended claw-receiving part 8 catch-couples to the flexible claw 14 on the box 13 and the appended claw-receiving part 9 catch-couples to the flexible claw 15, whereby the adaptor 1 is catch-coupled to the box 13.

By this, an ECU 2 having a different dimension from the receiving space of the box 13 can be received in this receiving space, and the box 13 can be made common among different vehicle types, for example, such as 4WD vehicles and hybrid vehicles.

Furthermore, in the adaptor 1, due to the fact that the first catch-coupling means is made as the appended claw-receiving part 8 and the appended claw-receiving part 9 corresponding to the flexible claw 14 and the flexible claw 15 on the box 13, when the ECU 2 is received inside the receiving space of the box 13 after the difference between the external dimension of the ECU 2 and the receiving space of the box 13 is adjusted by the adaptor 1, the need to make changes to the ECU 2 or the box 13 can be reduced, and accommodation can be made by changing only the adaptor 1.

Also, in the adaptor 1, by the fact that the direction of insertion-coupling of the insertion-coupling part 6 to the insertion-coupled part 11 and the direction of insertion-coupling of the insertion-coupling part 7 to the insertion-coupled part 12, and the direction of catch-coupling of the appended claw-receiving part 8 with the flexible claw 14 and the direction of catch-coupling of the appended claw-receiving part 9 with the flexible claw 15, are orthogonal, when the ECU 2 and the adaptor 1 made as one body or unit by insertion-coupling, are inserted inside the receiving space of the box 13 and are catch-coupled, the action of a force during catch-coupling influencing the insertion-coupling of the ECU 2 and the adaptor 1 by the insertion-coupling part 6 and the insertion-coupled part 11 and by the insertion-coupling part 7 and the insertion-coupled part 12 can be prevented.

With this, loosening of the insertion-coupling of the ECU 2 and the adaptor 1 is prevented, and receiving of the ECU 2 inside the box 13 can be accomplished smoothly.

Furthermore, after the adaptor 1 is rendered integral or a unit with the ECU 2, is inserted into the box 13 and is catch-coupled, the connector 10 of the ECU 2 is positioned toward the back in the direction of catch-coupling, here being the front-back direction of the vehicle, and the wiring distribution scheme of the ECU 2 is facilitated.

In Embodiment 1 described above, the differences of the dimensions of the ECU 2 and the box 13 in the vertical direction and in the front-back direction of the vehicle are adjusted by the adaptor 1, but the directions of adjustment can be changed suitably, and the differences of the dimensions in the vertical direction and the left-right direction of the vehicle also can be adjusted. Embodiment 2 concerning such is presented below.

### Embodiment 2

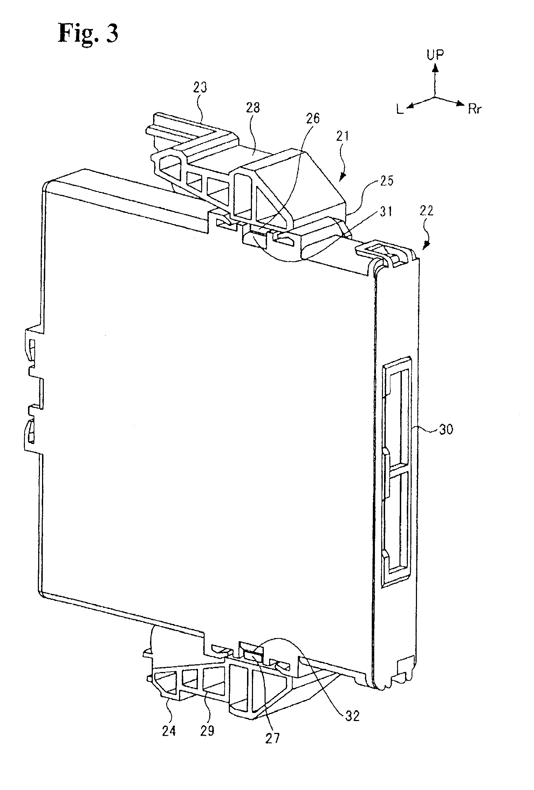

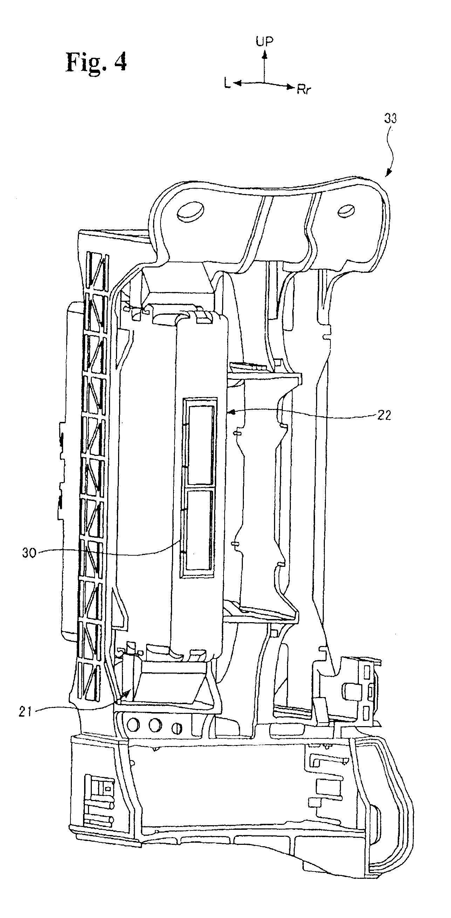

Fig. 3 is a drawing showing another embodiment of the attachment structure according to the present invention. Fig. 4 is a drawing showing the attachment structure according to the present invention. In Fig. 3 and Fig. 4, Rr indicates the rear of the vehicle, L indicates toward the left of the vehicle, and UP indicates upward.

The adaptor 21 of Embodiment 2 is used for adjusting a difference between an external dimension of an ECU 22 and a dimension of a receiving space of a box 33 for receiving this ECU 22, and has an upper part 23, a lower part 24, a connecting part 25, an insertion-coupling part 26, an insertion-coupling part 27, an appended claw-receiving part 28, and an appended claw-receiving part 29. Here also is unitarily constituted, for example, by polypropylene, or the like. In short, the adaptor 21 constitutes the adjusting member, the ECU 22 constitutes the electronic device, and the box 33 constitutes the receiving box.

Although not shown in detail here, this box 33 is joined such as by bolt-fastening to a dashboard reinforcement extending in the left-right direction of the vehicle inside the dashboard in front of the passenger seat side of the vehicle, and the direction of insertion, that is, catch-coupling of the adaptor 21 and the ECU 22 substantially coincides with the front-back direction of the vehicle.

The upper part 23 and the lower part 24 are connected by the connecting part 25 toward the right side of the vehicle from the ECU 22, and the adaptor 21 has an angle bracket shape that holds the ECU 22 inside from above and below. The difference of dimension of the ECU 22 and the receiving space of the box 33 in the vertical direction is adjusted by the dimension of the upper part 23 and lower part 24 in the vertical direction, and the difference of dimension of the ECU 22 and the receiving space of the box 33 in the left-right direction of the vehicle is adjusted by the dimension of the connecting part 25 in the left-right direction of the vehicle.

A connector 30 is provided on the back of the ECU 22 in the front-back direction of the vehicle, an insertion-coupled part 31 for insertion-coupling the ECU 22 to a bracket on the side of the vehicle body not illustrated here is provided on the upper end face, and an insertion-coupled part 32 for insertion-coupling to a bracket on the side of the vehicle body not illustrated here is provided on the lower face of the ECU 22.

The insertion-coupling part 26 of the adaptor 21 constitutes insertion-coupling means for sliding in the left-right direction of the vehicle, that is, in the direction of thickness of the ECU 22 and insertion-coupling to the insertion-coupled part 31 of the ECU 22, and the insertion-coupling part 27 of the adaptor 21 constitutes insertion-coupling means for sliding in the left-right direction of the vehicle, that is, in the direction of thickness of the ECU 22 and insertion-coupling to the insertion-coupled part 32 of the ECU 22.

Also, as shown in Fig. 4, the receiving space of the box 33 originally has a space capable of receiving an ECU for 4WD vehicle having larger dimensions than the ECU 22, but the ECU 22 having smaller dimensions than this receiving space is received because this box 33 is common among different vehicle types such as 4WD vehicles and hybrid vehicles.

Therefore, flexible claws not illustrated corresponding to claw-receiving parts on an ECU for 4WD vehicle having large dimensions are provided on the upper end face and lower end face of the receiving space of the box 33, and the adaptor 21 has an appended claw-receiving part 28 and an appended claw-receiving part 29 corresponding to the flexible claws on this box, and these appended claw-receiving parts 28, 29 constitute first catch-coupling means for catch-coupling the adaptor 21 and the box 33. Because the flexible claws described below are substantially the same as those presented in Embodiment 1, a detailed discussion is omitted.

Furthermore, in the adaptor 21, the direction of insertion-coupling and the direction of catch-coupling are orthogonal, with the direction of insertion-coupling of the insertion-coupling part 26 and the insertion-coupled part 31 and the direction of insertion-coupling of the insertion-coupling part 27 and the insertion-coupled part 32 being in the left-right direction of the vehicle, and the direction of catch-coupling of the appended claw-receiving part 28 and the flexible claw and the direction of catch-coupling of the appended claw-receiving part 29 and the flexible claw being the front-back direction of the vehicle.

According to the adaptor 21 and attachment structure of Embodiment 2 described above, the following operation and effect can be obtained in the same manner as Embodiment 1.

That is, the ECU 22 is insertion-coupled to the adaptor 21 by the insertion-coupling part 26 and the insertion-coupling part 27 of the adaptor 21. The ECU 22 and the adaptor 21 are made as a unit. The adaptor 21 is then inserted into the receiving space of the box 33, and the appended claw-receiving part 28 and the appended claw-receiving part 29 catch-couple to the flexible claws on the box 33, whereby the adaptor 21 is catch-coupled to the box 33.

With this, an ECU 22 having a different dimension from the receiving space of the box 33 can be received inside this receiving space. Accordingly, the box 33 can be made common among different vehicle types, for example, such as 4WD vehicles and hybrid vehicles.

Furthermore, in the adaptor 21, due to the fact that the first catch-coupling means is made as the appended claw-receiving part 28 and the appended claw-receiving part 29 corresponding to the flexible claws on the box 33, when the ECU 22 is received inside the receiving space of the box 33 after the difference between the external dimension of the ECU 22 and the receiving space of the box 33 is adjusted by the adaptor 21, the need to make changes to the ECU 22 or the box 33 can be reduced, and accommodation can be made by changing only the adaptor 21.

Also, in the adaptor 21, due to the fact that the direction of insertion-coupling of the insertion-coupling part 26 to the insertion-coupled part 31 and the direction of insertion-coupling of the insertion-coupling part 27 to the insertion-coupled part 32, and the direction of catch-coupling of the appended claw-receiving part 28 and the appended claw-receiving part 29 with the flexible claws of the box 33 are orthogonal, the following operation and effect can be obtained.

That is, when the ECU 22 and the adaptor 21, made as a unit by insertion-coupling, are inserted inside the receiving space of the box 33 and are catch-coupled, the action of a force during catch-coupling influencing the insertion-coupling of the ECU 22 and the adaptor 21 by the insertion-coupling part 26 and the insertion-coupled part 31 and by the insertion-coupling part 27 and the insertion-coupled part 32, can be prevented. Therefore, loosening of the insertion-coupling of the ECU 22 and the adaptor 21 is prevented, and receiving of the ECU 22 inside the box 33 can be accomplished smoothly.

Furthermore, after the adaptor 21, made as a unit with the ECU 22, is inserted into the box 33 and is catch-coupled, the connector 30 of the ECU 22 is positioned toward the back in the direction of catch-coupling, in this instance being the front-back direction of the vehicle. The wiring distribution scheme of the ECU 22 can accordingly be facilitated.

In Embodiment 2 described above, the differences of the dimensions of the ECU 22 and the box 33 in the vertical direction and in the left-right direction of the vehicle are adjusted by the adaptor 21. However, the directions of adjustment can be changed suitably, and the construction also may be such that the differences of the dimensions in the vertical direction and the front-back direction of the vehicle are adjusted, the catch-coupling means are not provided on the adaptor, and the ECU has a first catch-coupling means for catch-coupling to the box. Embodiment 3 concerning such is presented below.

### Embodiment 3

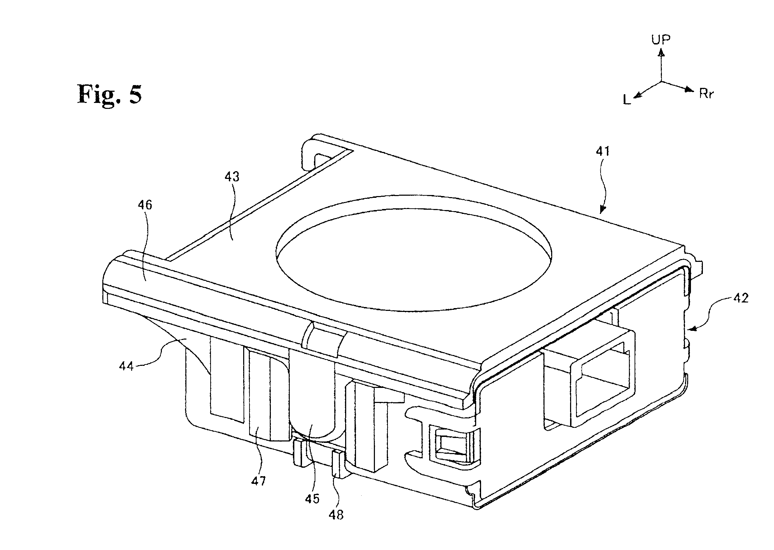

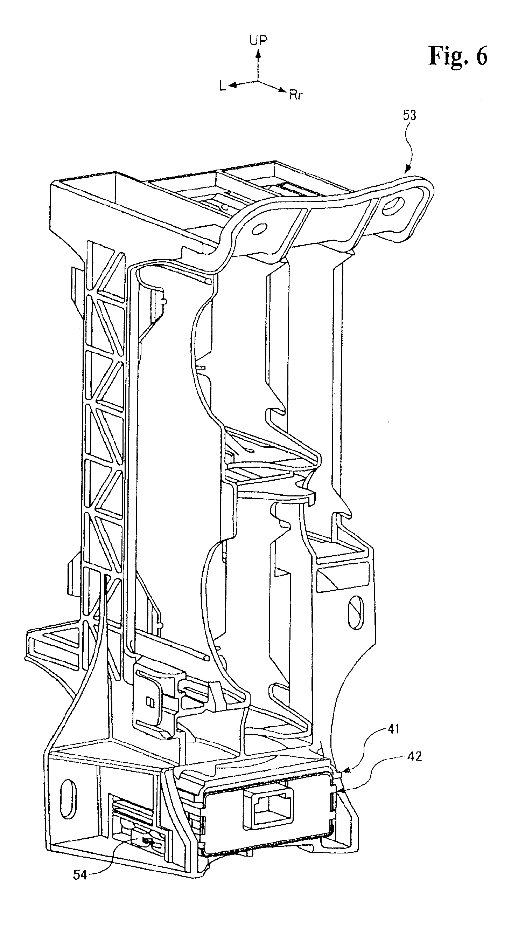

Fig. 5 is a drawing showing another embodiment of the attachment structure according to the present invention. Fig. 6 is a drawing showing the attachment structure according to the present invention. In Fig. 5 and Fig. 6, Rr indicates toward the rear of the vehicle, L indicates toward the left of the vehicle, and UP indicates upward.

The adaptor 41 of Embodiment 3 is used for adjusting a difference between an external dimension of an ECU 42 and a dimension of a receiving space of a box 53 for receiving this ECU 42, and has an upper face part 43, a pair of side parts 44 on the left and right, a pair of insertion-coupling parts 45 on the left and right, and a pair of improper receiving preventing slots 46 on the left and right, and here also is unitarily constructed, for example, of polypropylene, or the like. The ECU 42 has a pair of insertion-coupled parts 47 on the left and right, and a stopper 48. In short, the adaptor 41 constitutes the adjusting member, the ECU 42 constitutes the electronic device, and the box 53 constitutes the receiving box.

Although not shown in detail here, this box 53 is joined such as by bolt-fastening to a dashboard reinforcement extending in the left-right direction of the vehicle inside the dashboard in front of the passenger seat side of the vehicle, and the direction of insertion, that is, catch-coupling of the adaptor 41 and the ECU 42 substantially coincides with the front-back direction of the vehicle.

The pair of side parts 44 on the left and right are connected on the upper face part 43 above the ECU 42, and the adaptor 41 has an angle bracket shape that holds the ECU 42 inside from the left-right direction of the vehicle. The difference of dimension of the ECU 42 and the receiving space of the box 53 in the left-right direction of the vehicle is adjusted by the dimension of these side parts 44 in the left-right direction of the vehicle, and the difference of dimension of the ECU 42 and the receiving space of the box 53 in the vertical direction is adjusted by the dimension of the upper face part 43 in the vertical direction.

The insertion-coupling part 45 of the adaptor 41 constitutes an insertion-coupling means for sliding the adaptor 41 in the vertical direction of the vehicle, that is, in the direction of thickness of the ECU 42 and insertion-coupling to the ECU 42, and the insertion-coupling parts 45 insertion-couple to the insertion-coupled parts 47 of the ECU 42.

Also, as shown in Fig. 6, the receiving space of the box 53 originally has a space capable of receiving an ECU for 4WD vehicle having larger dimensions than the ECU 42, but the ECU 42 having smaller dimensions than this receiving space is received because this box 53 is to be made common among different vehicle types such as 4WD vehicles and hybrid vehicles.

Therefore, flexible claws 54 corresponding to claw-receiving parts on an ECU for 4WD vehicle having large dimensions are provided on the left end face and right end face of the receiving space of the box 53, and the ECU 42 has stoppers 48 corresponding to the flexible claws 54 on this box, and the ECU 42 is catch-coupled to the box 53 by catch-coupling of the flexible claws 54 to these stoppers 48. In short, the stoppers 48 constitute first catch-coupling means.

Furthermore, the direction of insertion-coupling of the adaptor 41 to the ECU 42 and the direction of catch-coupling of the ECU 42 to the box 53 are orthogonal.

According to the adaptor 41 and attachment structure of Embodiment 3 described above, the following operation and effect can be obtained in the same manner as Embodiment 1 and Embodiment 2.

That is, the ECU 42 is insertion-coupled to the adaptor 41 by the insertion-coupling parts 45 of the adaptor 41, and the ECU 42 and the adaptor 41 are rendered one body or unit. The ECU 42 and the adaptor 41 are then inserted into the receiving space of the box 53, and the stoppers 48 catch-couple to the flexible claws 54 on the box 53, whereby the ECU 42 is catch-coupled to the box 53.

With this, an ECU 42 having a different dimension from the receiving space of the box 53 can be received inside this receiving space, and the box 53 can be made common among different vehicle types, for example, such as 4WD vehicles and hybrid vehicles, and among ECUs 42 having different sizes, for example, because of different numbers of system circuits.

Also, by the fact that the direction of insertion-coupling of the insertion-coupling parts 45 of the adaptor 41 to the insertion-coupled parts 47 of the ECU 42 is made orthogonal to the direction of catch-coupling of the ECU 42 to the box 53, the following operation and effect can be obtained.

That is, when the ECU 42 and the adaptor 41 rendered a unit by insertion-coupling, are inserted into the receiving space of the box 53 and are catch-coupled, the action of a force during catch-coupling influencing the insertion-coupling of the ECU 42 and the adaptor 41 by the insertion-coupling parts 45 and the insertion-coupled parts 47 can be prevented. Therefore, loosening of the insertion-coupling of the ECU 42 and the adaptor 41 is prevented, and reception of the ECU 42 inside the box 53 can be accomplished smoothly.

Also, by the fact that the adaptor 41 has a pair of improper receiving preventing slots 46 on the left and right, and the upper edge demarcating the receiving space of the box 53 has projecting parts corresponding to the improper receiving preventing slots 46, in the case when there is an attempt to insert the ECU 42 and the adaptor 41 upside-down, these projecting parts contact with the stoppers 48 in mid-insertion and further insertion becomes impossible. Accordingly, insertion of the ECU 42 into the box 53 upside-down can be prevented. In short, the improper receiving preventing slots 46 constitute preventing means for preventing improper receiving.

The adaptor according to the present invention is not limited to the modes explained in Embodiments 1 to 3, and can also be made as a binary or two piece structure as below. Embodiment 4 concerning such is presented below.

### Embodiment 4

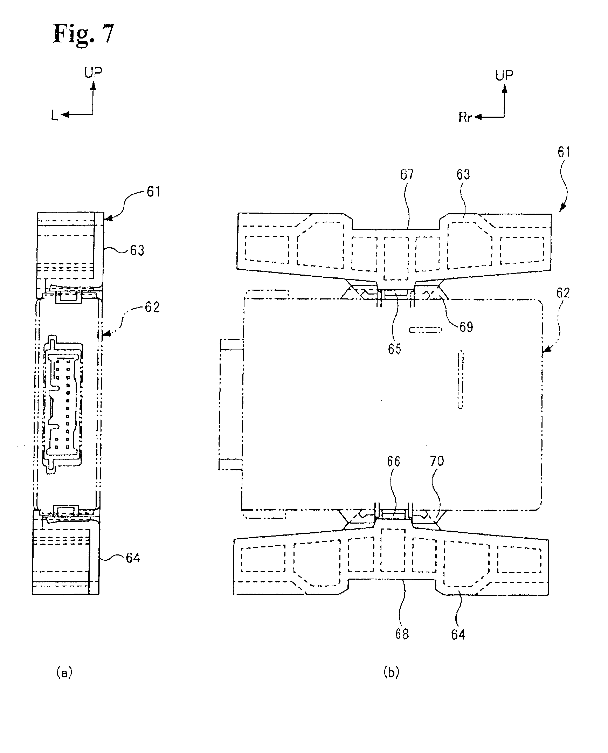

Figs. 7 (a) and 7(b) are drawings showing a further embodiment of the attachment structure according to the present invention. In Figs. 7 (a) and 7(b), Rr indicates toward the rear of the vehicle, L indicates toward the left of the vehicle, and UP indicates upward.

The adaptor 61 of Embodiment 4 is used for adjusting a difference between an external dimension of an ECU 62 and a dimension of a receiving space of a box not illustrated here for receiving this ECU 62, and has an upper part 63, a lower part 64, an insertion-coupling part 65, an insertion-coupling part 66, an appended claw-receiving part 67, and an appended claw-receiving part 68, and here also is integrally constituted, for example, by polypropylene, or the like. In short, the adaptor 61 constitutes the adjusting member, the ECU 62 constitutes the electronic device, and the box not illustrated constitutes the receiving box.

The adaptor 61 has a binary structure comprising the upper part 63 and the lower part 64. On the upper part 63, the insertion-coupling part 65 as an insertion-coupling means is formed on the lower side and the appended claw-receiving part 67 is formed on the upper side. On the lower part 64, the insertion-coupling part 66 as an insertion-coupling means is formed on the upper side and the appended claw-receiving part 68 is formed on the lower side. In addition, on the adaptor 61 having this binary structure, the insertion-coupling part 65 on one side, being the upper part 63, and the insertion-coupling part 66 on the other side, being the lower part 64, are positioned in the center in the direction of catch-coupling, that is, the front-back direction of the vehicle.

The upper part 63 of the adaptor 61 is insertion-coupled to the ECU 62 by sliding laterally in the left-right direction of the vehicle, that is, the direction of thickness of the ECU 62 and insertion-coupling the insertion-coupling part 65 to an insertion-coupled part 69 on the ECU 62, and the lower part 64 of the adaptor 61 is insertion-coupled to the ECU 62 by sliding in the left-right direction of the vehicle, that is, the direction of thickness of the ECU 62 and insertion-coupling the insertion-coupling part 66 to an insertion-coupled part 70 on the ECU 62. The difference of dimension of the ECU 62 and the receiving space of the box, not illustrated, in the vertical direction is adjusted by the dimension of the upper part 63 and lower part 64 combined in the vertical direction.

Also, the receiving space of the box not illustrated originally has a space capable of receiving an ECU having larger dimensions than the ECU 62, but the ECU 62 having smaller dimensions than this receiving space is received because this box is to be made common among different vehicle types such as 4WD vehicles and hybrid vehicles.

Therefore, flexible claws, not illustrated, corresponding to claw-receiving parts on an ECU for 4WD vehicle having large dimensions, are provided on the upper end face and lower end face of the receiving space of the box, not illustrated, and the upper part 63 and lower part 64 of the adaptor 61 have an appended claw-receiving part 67 and an appended claw-receiving part 68 corresponding to the flexible claws on this box. These appended claw-receiving parts 67, 68 constitute first catch-coupling means for catch-coupling the adaptor 61 and the box, not illustrated.

Furthermore, in the adaptor 61, the direction of insertion-coupling and the direction of catch-coupling are made orthogonal, with the direction of insertion-coupling of the insertion-coupling part 65 and the insertion-coupled part 69 and the direction of insertion-coupling of the insertion-coupling part 66 and the insertion-coupled part 70 being the left-right direction of the vehicle, and the direction of catch-coupling of the appended claw-receiving part 67 and the flexible claw and the direction of catch-coupling of the appended claw-receiving part 68 and the flexible claw being the front-back direction of the vehicle. In addition, the adaptor 61 having a binary structure is constituted such that the insertion-coupling part 65 on the upper part 63 on one side and the insertion-coupling part 66 on the lower part 64 on the other side are positioned in the center in the direction of catch-coupling.

According to the adaptor 61 and attachment structure of Embodiment 4 described above, the following operation and effect can be obtained in the same manner as Embodiments 1 to 3.

That is, the ECU 62 is insertion-coupled to the adaptor 61 by the insertion-coupling part 65 and the insertion-coupling part 66 of the adaptor 61, and the ECU 62 and the adaptor 61 are made as a unit, then the adaptor 61 is inserted inside the receiving space of the box not illustrated, and the appended claw-receiving part 67 and the appended claw-receiving part 68 catch-couple to the flexible claws on the box, whereby the adaptor 61 is catch-coupled to the box.

By this, an ECU 62 having a different dimension from the receiving space of the box can be received inside this receiving space, and the box can be made common among different vehicle types, for example, such as 4WD vehicles and hybrid vehicles.

Furthermore, in the adaptor 61, by the fact that the first catch-coupling means is made as the appended claw-receiving part 67 and the appended claw-receiving part 68 corresponding to the flexible claws on the box, when the ECU 62 is received inside the receiving space of the box after the difference between the external dimension of the ECU 62 and the receiving space of the box is adjusted by the adaptor 61, the need to make changes to the ECU 62 or the box can be reduced, and accommodation can be made by changing only the adaptor 61.

Also, in the adaptor 61, by the fact that the direction of insertion-coupling of the insertion-coupling part 65 to the insertion-coupled part 69 and the direction of insertion-coupling of the insertion-coupling part 66 to the insertion-coupled part 70, and the direction of catch-coupling of the appended claw-receiving part 67 and the appended claw-receiving part 68 with the flexible claws of the box are made orthogonal, the following operation and effect can be obtained.

That is, when the ECU 62 and the adaptor 61 made as a unit by insertion-coupling are inserted inside the receiving space of the box not illustrated and are catch-coupled, the action of a force during catch-coupling influencing the insertion-coupling of the ECU 62 and the adaptor 61 by the insertion-coupling part 65 and the insertion-coupled part 69 and by the insertion-coupling part 66 and the insertion-coupled part 70 can be prevented. Therefore, loosening of the insertion-coupling of the ECU 62 and the adaptor 61 is prevented, and receiving of the ECU 62 inside the box can be accomplished smoothly.

Also, by the fact that the adaptor 61 is made as a binary structure, the connecting part for connecting the upper part 63 and the lower part 64 can be eliminated, therefore the influence of this connecting part in the front-back direction of the vehicle or the left-right direction of the vehicle on the receiving space is prevented, and a more advantageous arrangement can be made in the case when adjustment is made only in the vertical direction of the ECU 62 and the receiving space of the box.

Furthermore, because the insertion-coupling part 65 on the upper part 63 on one side and the insertion-coupling part 66 on the lower part 64 on the other side of the adaptor 61 having a binary structure are positioned in the center in the direction of catch-coupling, the upper part 63 on one side and the lower part 64 on the other side of the adaptor 61 having a binary structure can be made common.

In Embodiments 1 to 4 described above, the arrangement was made such that the adaptor and the ECU as object are first insertion-coupled as a unit and then received into the box, nevertheless, the arrangement can also be made such that the receiving space is adjusted in advance by first fixing the adaptor into the box, and then the ECU as an object is inserted into the receiving space. Embodiment 5 concerning such is presented below.

### Embodiment 5

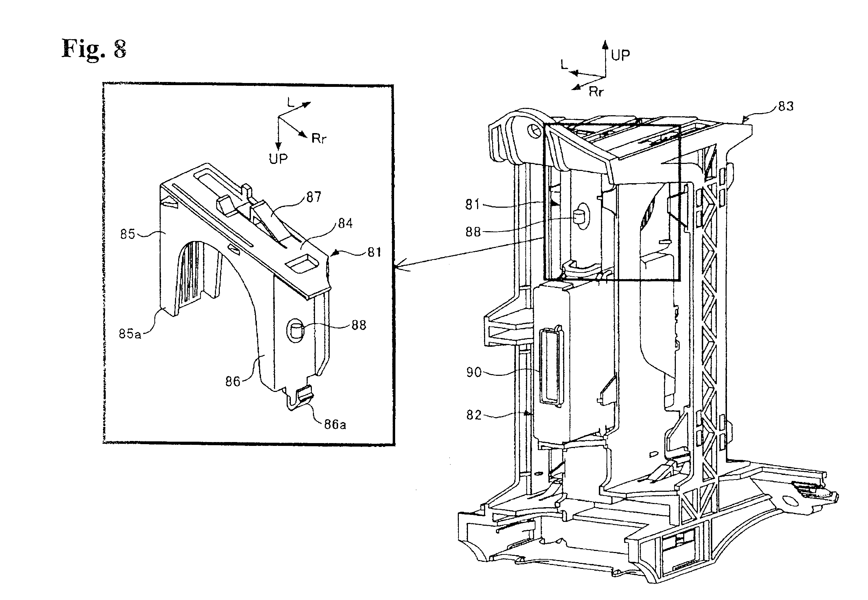

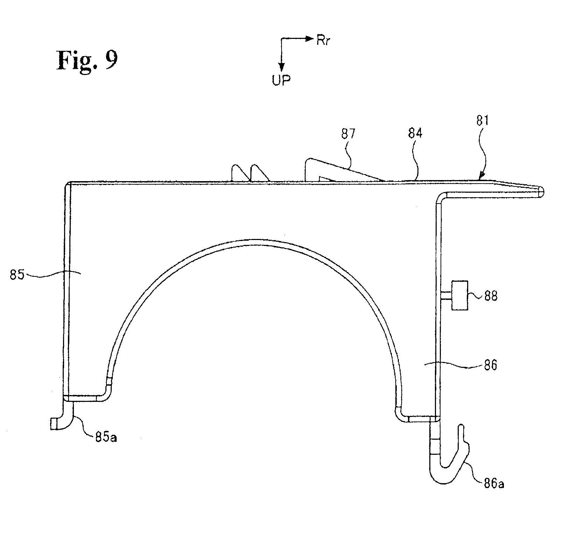

Fig. 8 is a drawing showing another embodiment of the attachment structure according to the present invention. Fig. 9 is a drawing showing a further embodiment of the attachment structure according to the present invention. In Fig. 8, Rr indicates toward the rear of the vehicle, L indicates toward the left of the vehicle, and UP indicates upward.

The adaptor 81 of Embodiment 5 is used for adjusting a difference between an external dimension of an ECU 82 and a dimension of a receiving space of a box 83 for receiving this ECU 82, and has a bottom floor part 84, a front post part 85, and a rear post part 86, and here is integrally constituted by engineering plastic, for example, such as polyacetal, or the like. In short, the adaptor 81 constitutes the adjusting member, the ECU 82 constitutes the electronic device, and the box 83 constitutes the receiving box.

Although not shown in detail here, this box 83 is joined such as by bolt-fastening to a dashboard reinforcement extending in the left-right direction of the vehicle inside the dashboard in front of the passenger seat side of the vehicle, and the direction of insertion, that is, catch-coupling of the adaptor 81 and the ECU 82 substantially coincides with the front-back direction of the vehicle.

A claw part 85a is provided on the upper end of the front post part 85 and a claw part 86a is provided on the upper end of the rear post part 86, and the respective claw parts 85a and 86a lock into corresponding cutout holes provided on the upper end face of the receiving space of the box 83 for the ECU 82, whereby the adaptor 81 is fixed to the box 83. That is, the claw part 85a and the claw part 86a constitute fixing means for fixing the adaptor 81 to the box 83.

Furthermore, an appended flexible claw 87 corresponding a claw-receiving part on the upper end face of the ECU 82 is provided on the lower end face of the adaptor 81, and this appended flexible claw 87 constitutes second catch-coupling means for catch-coupling the adaptor 81 and the ECU 82.

Furthermore, a clamp 88 as clamping means for clamping wiring of the ECU 82 is provided on the back end face of the adaptor 81. In addition, the ECU 82 has a connector 90 on the back in the front-back direction of the vehicle.

The difference of dimension of the ECU 82 and the receiving space of the box 83 in the vertical direction is adjusted by the dimension of the adaptor 81 in the vertical direction.

Also, the receiving space of the box 83 originally has a space capable of receiving an ECU for 4WD vehicle having larger dimensions than the ECU 82, but the ECU 82 having smaller dimensions than this receiving space is received because this box 83 is to be made common among different vehicle types such as 4WD vehicles and hybrid vehicles.

Therefore, a flexible claw, not illustrated, corresponding to a claw-receiving part on an ECU for 4WD vehicle having large dimensions is provided on the lower end face of the receiving space of the box 83, and the claw-receiving part on the lower end face of the ECU 82 catch-couples to this flexible claw, and the claw-receiving part on the upper end face of the ECU 82 catch-couples to the appended flexible claw 87 on the lower end face of the adaptor 81, whereby the ECU 82 is received inside the receiving space of the box 83.

According to the adaptor 81 and attachment structure of Embodiment 5 described above, the following operation and effect can be obtained.

According to this, the adaptor 81 is fixed to the box 83 by the claw part 85a and the claw part 86a and the adaptor 81 and the box 83 are formed into a unit, then the ECU 82 is inserted inside the receiving space of the box 83 being adjusted in the vertical direction by the adaptor 81, and the ECU 82 is catch-coupled to the box 83 and the adaptor 81 by the appended flexible claw 87, whereby an ECU 82 having a different dimension from the receiving space of the box 83 can be received inside the receiving space. By this, the box 83 can be made common among different vehicle types.

Also, second catch-coupling means can be made as the appended flexible claw 87 corresponding to the original claw-receiving part of the ECU 82, and when the ECU 82 is received inside the receiving space of the box 83 after the difference between the external dimension of the ECU 82 and the receiving space of the box 83 is adjusted by the adaptor 81, accommodation can be made by changing only the side of adaptor 81 without making changes to the ECU 82 or the box 83.

Furthermore, by the fact that the adaptor 81 has a clamp 88, the wiring of the ECU 82 can be clamped using the adaptor 81 positioned between the ECU 82 and the box 83, and the adaptor 81 can be utilized more effectively, and the degree of freedom of the wiring scheme of the ECU 82 can be increased with the direction of the distribution scheme of the wiring from the connector 90 of the ECU 82 being determined by the clamp 88.

In comparison with the constitution presented in Embodiments 1 to 4, the adaptor 81 presented in Embodiment 5 has an appended flexible claw 87, and in order to ensure flexibility, engineering plastic such as polyacetal must be used as the material applied to the adaptor 81, therefore the adaptor of Embodiments 1 to 4 is advantageous from the viewpoint of cost reduction.

Preferred embodiments of the present invention have been explained in detail above, however, the present invention is not limited thereto and various modifications and substitutions to the embodiments described above are possible without deviating from the scope of the present invention.

In the above examples, the case wherein the direction of insertion of the ECU or adaptor into the box coincides with the front-back direction of the vehicle is disclosed. This is, of course, merely illustrative and no limitation is applied with regard to the placement of the box onto the side of the vehicle body or the direction of adjustment of dimensions by the adaptor.

Also, the ECU in the embodiments described above can be of various kinds of ECUs used in vehicles, and a plurality of ECUs of different kinds also can be combined.

### Industrial Utility

According to the attachment structure of the present invention, a receiving box for centrally receiving a vehicle-mounted electronic device can be made common among vehicle types, and therefore it is advantageous when applied to all kinds of vehicles such as common passenger cars, trucks, and buses.
The specification, claims, drawings, and abstract of Japanese Patent Application No. 2007-210859 filed on August 13, 2007 are incorporated in their entirety herein and are incorporated as a disclosure of the present invention.

## Claims

1. An attachment structure for attaching a vehicle-mounted electronic device to a receiving box using an adjusting member for adjusting a difference between an external dimension of the electronic device and a dimension of a receiving space of the receiving box configured for receiving the electronic device,
wherein the adjusting member has insertion-coupling means for insertion-coupling the adjusting member and the electronic device;
the adjusting member or the electronic device has first catch-coupling means for catch-coupling the adjusting member or the electronic device and the receiving box;
the first catch-coupling means is an appended claw-receiving part that corresponds to a flexible claw on the receiving box; and
a direction of insertion-coupling of the insertion-coupling means and a direction of catch-coupling of the first catch-coupling means are respectively different.

2. The attachment structure recited in claim 1, wherein the direction of insertion-coupling of the insertion-coupling means and the direction of catch-coupling of the first catch-coupling means are orthogonal.

3. The attachment structure recited in claim 1 or 2,
wherein the flexible claw has an edge part that faces a front in the direction of catch-coupling, and an inclined face that inclines away from the electronic device from a front to back in the direction of catch-coupling; and the appended claw-receiving part has a wall part oriented toward a front in the direction of catch-coupling.

4. The attachment structure recited in any one of claims 1 to 3, wherein the electronic device has a connector located at a back of the electronic device in the direction of catch-coupling; and the adjusting member has an upper part and a lower part, and a connecting part connecting the upper part and the lower part at a location toward a front of the adjusting member in the direction of catch-coupling.

5. The attachment structure recited in any one of claims 1 to 3, wherein the electronic device has a connector located toward a back of the electronic device in the direction of catch-coupling; and the adjusting member has an upper part and a lower part, and a connecting part connecting the upper part and the lower part at a location laterally displaced with respect to the direction of catch-coupling.

6. The attachment structure recited in any one of claims 1 to 3, wherein the adjusting member is a two piece binary structure.

7. The attachment structure recited in claim 6, wherein the insertion-coupling means on one side and the insertion-coupling means on the other side of the adjusting member having the binary structure are positioned in a center location of each piece of binary structure in the direction of catch-coupling.

8. The attachment structure recited in any one of claims 1 to 7, wherein the adjusting member has preventing means for preventing an improper insertion orientation when inserting the electronic device in the receiving space of the receiving box.

9. An attachment structure for attaching a vehicle-mounted electronic device to a receiving box using an adjusting member for adjusting a difference between an external dimension of the electronic device and a dimension of a receiving space of the receiving box for receiving the electronic device,
wherein the adjusting member has fixing means for fixing the adjusting member in the receiving box, and second catch-coupling means for catch-coupling the adjusting member and the electronic device,
the second catch-coupling means is an appended flexible claw that corresponds to a claw-receiving part on the electronic device, and the adjusting member has clasping means for clasping wiring of the electronic device.

10. The attachment structure recited in claim 9, wherein the electronic device has a connector toward a back of the electronic device in a direction of insertion direction into the receiving box; and the adjusting member has the clasping means at a location toward a back of the adjusting member in the direction of insertion.
